# EUROPÄISCHE PATENTANMELDUNG

(11) **EP 3 916 403 A1**
(43) Veröffentlichungstag der Anmeldung: **01.12.2021**
(21) Anmeldenummer: 20176516.1
(22) Anmeldetag: 26.05.2020
(51) Int. Cl.: G01R 31/27, H01H 33/59, H03K 17/18, H03K 17/66

(54) **SCHALTGERÄT FÜR EIN GLEICHSPANNUNGSNETZ UND BETRIEBSVERFAHREN FÜR DAS SCHALTGERÄT**

(71) Anmelder: Siemens Aktiengesellschaft, 80333 München (DE)
(72) Erfinder: Handt, Karsten, 92348 Berg (DE); Hänsel, Stefan, 91083 Baiersdorf (DE)

(57) **Zusammenfassung**

Schaltgerät für ein Gleichspannungsnetz mit einem ersten steuerbaren Halbleiterschalter, der einen Steuerkontakt und zwei Lastkontakte aufweist und einer Steuerung für den ersten Halbleiterschalter, ausgestaltet, den ersten Halbleiterschalter mittels eines elektrischen Steuersignals am Steuerkontakt zu steuern, wobei die Steuerung ausgestaltet ist, folgende Schritte vorzunehmen:
- Ansteuern des ersten Halbleiterschalters mit einem Steuerimpuls, der bei einem funktionstüchtigen Halbleiterschalter ein Herabsetzen der elektrischen Leitfähigkeit des Halbleiterschalters bewirkt, für eine Zeitspanne, die weniger als 1 ms beträgt,
- Aufprägen eines Stroms auf eine Prüfschaltung, die den ersten Halbleiterschalter umfasst,
- Ermitteln eines die Spannung oder die Spannungsänderung über den ersten Halbleiterschalter repräsentierenden ersten Werts als Folge des Steuerimpulses und des Aufprägens,
- Ermitteln aus dem ersten Wert und Ausgabe eines Signals, das die Funktionstüchtigkeit des ersten Halbleiterschalters repräsentiert.

## Beschreibung

Schaltgeräte für Gleichspannungsnetze werden in solchen Netzen eingesetzt, um einzelne Verbraucher, aber auch Teilnetze (Netzzweige oder Lastbereiche) vom Rest des Gleichspannungsnetzes zu trennen. Diese Trennung kann eine beabsichtigte Abschaltung durch einen Schaltbefehl einer übergeordneten Steuerung darstellen oder aber im Sinne einer Schutzfunktion vom Schaltgerät selbst bewirkt werden, beispielsweise im Fehlerfall.

Dabei hat es sich als vorteilhaft erwiesen, steuerbare Halbleiterschalter wie beispielsweise IGBTs in solchen Schaltgeräten einzusetzen. Dabei ist typischerweise wenigstens einer der Halbleiterschalter eines Schaltgeräts im Laststrompfad angeordnet und übernimmt im eingeschalteten Zustand den vollen Laststrom. Im Normalbetrieb ist der Halbleiterschalter also dauerhaft eingeschaltet. In einem solchen Normalbetrieb können daher nur Defekte erkannt werden, die den Schalter hochohmig werden lassen. Alle Defekte, die dazu führen, dass der Schalter nicht mehr in der Lage ist, Blockierspannung aufzubauen, werden erst beim nächsten Ausschalten erkannt, also beim Versagen des Schalters. Ein Schutz der Anlage ist in diesem Falle nicht mehr gegeben.

Bei bidirektionalen Schaltgeräten sind in der Regel zwei Halbleiterschalter anti-seriell im Laststrompfad angeordnet. Häufig werden solche Halbleiterschalter verwendet, die als Bauteil oder intrinsisch eine parallele Freilaufdiode umfassen, beispielsweise IGBTs. Bei diesen bleibt sogar bei der nächsten Abschaltung unerkannt, dass einer der Halbleiterschalter leitend defekt ist, wenn die Stromrichtung derartig ist, dass die Freilaufdiode den Spannungsaufbau über diesen Halbleiterschalter verhindert, also der andere - nicht defekte - der beiden Halbleiterschalter die Blockierspannung aufbaut.

Es ist Aufgabe der vorliegenden Erfindung, ein Schaltgerät anzugeben, das den genannten Nachteil vermeidet, insbesondere eine Funktionsprüfung unabhängig von der Stromrichtung erlaubt. Eine weitere Aufgabe besteht darin, ein verbessertes Betriebsverfahren für ein solches Schaltgerät anzugeben.

Diese Aufgabe wird durch ein Schaltgerät mit den Merkmalen von Anspruch 1 gelöst. Eine weitere Lösung besteht in dem Betriebsverfahren mit den Merkmalen von Anspruch 9.

Das erfindungsgemäße Schaltgerät für ein Gleichspannungsnetz weist einen ersten steuerbaren Halbleiterschalter auf, beispielsweise einen IGBT, der einen Steuerkontakt und zwei Lastkontakte aufweist. Weiterhin umfasst das Schaltgerät eine Steuerung für den ersten Halbleiterschalter, die ausgestaltet ist, den ersten Halbleiterschalter mittels eines elektrischen Steuersignals am Steuerkontakt zu steuern, also beispielsweise mit einer Spannung am Gate oder einem Steuerstrom.

Die Steuerung ist ausgestaltet, den ersten Halbleiterschalter mit einem Steuerimpuls anzusteuern, der bei einem funktionstüchtigen Halbleiterschalter ein Herabsetzen der elektrischen Leitfähigkeit des Halbleiterschalters bewirkt, für eine Zeitspanne, die weniger als 1 ms beträgt.

Weiterhin ist das Schaltgerät ausgestaltet, einen Strom auf eine Prüfschaltung aufzuprägen, wobei die Prüfschaltung den ersten Halbleiterschalter umfasst. Ein die Spannung oder die Spannungsänderung über den ersten Halbleiterschalter repräsentierender erster Wert wird als Folge des Steuerimpulses und des Aufprägens erfasst und ermittelt. Aus dem ersten Wert wiederum wird ein Signal abgeleitet und ausgegeben, das die Funktionstüchtigkeit des ersten Halbleiterschalters repräsentiert.

Durch das Abschalten des ersten Halbleiterschalters und das Aufprägen des Stroms auf die Prüfschaltung, die den ersten Halbleiterschalter umfasst, wird also vorteilhaft eine Funktionsprüfung für den Schalter ermöglicht, die nicht davon abhängt, dass der erste Halbleiterschalter auch tatsächlich selbst eine Blockierspannung aufbaut.

Besonders vorteilhaft ist das, wenn das Schaltgerät einen zweiten steuerbaren Halbleiterschalter umfasst. In diesem Fall kann die Steuerung ausgestaltet sein, beide Halbleiterschalter mit dem Steuerimpuls anzusteuern, um den Laststrom für kurze Zeit abzuschalten. Dabei ist es vorteilhaft, wenn das Schaltgerät ein Entlastungsnetzwerk umfasst, das parallel zu den Halbleiterschaltern angeordnet ist und für die kurze Zeitspanne der Abschaltung den Laststrom übernimmt und dabei eine nicht zu große Spannung aufbaut.

Umfassen die Halbleiterschalter jeweils eine parallele Freilaufdiode und sind anti-seriell geschaltet, dann bewirkt der Steuerimpuls einen Spannungsaufbau nur bei einem der beiden Halbleiterschalter. Welcher der beiden Halbleiterschalter betroffen ist, hängt von der Stromrichtung des Laststroms ab. Im Folgenden wird davon ausgegangen, dass es der zweite Halbleiterschalter ist. Dann wird beim ersten Halbleiterschalter der Spannungsaufbau durch die Freilaufdiode begrenzt. Die Steuerung kann ausgestaltet sein, zusätzlich einen die Spannung oder die Spannungsänderung über den zweiten Halbleiterschalter repräsentierenden zweiten Wert als Folge des Steuerimpulses zu ermitteln. Aus beiden ermittelten Werten wird ein Signal bestimmt und ausgegeben, das die Funktionstüchtigkeit beider Halbleiterschalter repräsentiert.

Weitere vorteilhafte Ausgestaltungen des erfindungsgemäßen Schaltgeräts und des Betriebsverfahrens gehen aus den abhängigen Ansprüchen hervor. Dabei können die Ausführungsformen der unabhängigen Ansprüche mit den Merkmalen eines der Unteransprüche oder vorzugsweise auch mit denen aus mehreren Unteransprüchen kombiniert werden. Demgemäß können noch zusätzlich folgende Merkmale vorgesehen sein:
Die Steuerung kann ausgestaltet sein, als Zeitspanne weniger als 10 µs, insbesondere weniger als 5 µs zu verwenden. Aus diesen kurzen Schaltzeiten ergibt sich ein vorteilhaft sehr geringer Einfluss auf den laufenden Betrieb. Der Spannungsaufbau, der sich durch die im Gleichspannungsnetz gespeicherte Energie über parallel zu den Halbleiterschaltern vorliegenden Kapazitäten beispielsweise eines Entlastungsnetzwerks ergibt, bleibt dadurch gering. Speziell für kapazitive Lasten wird dadurch der Ausgleichsstrom beim Wiedereinschalten geringgehalten.

Die Steuerung kann ausgestaltet sein, mit dem Steuerimpuls eine verringerte Leitfähigkeit des oder der Halbleiterschalter zu bewirken, aber kein Abschalten. Während die entsprechende Ansteuerschaltung, beispielsweise Gatebeschaltung, geeignet dafür sein muss, ermöglicht das vorteilhaft eine sanftere Funktionsprüfung mit weniger Rückwirkung auf den Netzbetrieb als die völlige Abschaltung.

Die Steuerung kann alternativ ausgestaltet sein, den oder die Halbleiterschalter mit dem Steuerimpuls völlig abzuschalten, also - sofern sie funktionstüchtig sind - sie in den nichtleitenden Zustand zu bringen. Daraus ergibt sich ein deutlicheres Signal gegenüber einer Absenkung der Leitfähigkeit und die Ansteuerung des Steuerkontakts erfordert keinen Zusatzaufwand, da eine Abschaltung ohnehin möglich sein muss.

Das Schaltgerät kann, sofern es zwei Halbleiterschalter umfasst, auch eine Prüfschaltung für jeden der Halbleiterschalter aufweisen. Da die Prüfschaltung für die Funktionsprüfung desjenigen Halbleiterschalters nötig ist, der bei Abschaltung weitgehend spannungsfrei bleibt, ermöglicht das die Funktionsprüfung beider Halbleiterschalter unabhängig von der Stromrichtung.

Die Prüfschaltung kann einen resistiven Spannungsteiler umfassen, zu dessen einem Widerstand der erste oder der zweite Halbleiterschalter parallelgeschaltet ist. Damit wird eine einfache und direkte Umsetzung der Blockierfähigkeit des Halbleiterschalters in einen repräsentierenden Wert - eine Spannung - ermöglicht.

Die Widerstände des resistiven Spannungsteilers können vorteilhaft Widerstandwerte von weniger als 10 kOhm, insbesondere weniger als 5 kOhm aufweisen. Über die Werte der Widerstände und eine angelegte Prüfspannung ergibt sich der Stromfluss durch die Lastkontakte des zu prüfenden Halbleiterschalters. Der Stromfluss wiederum stellt die Geschwindigkeit ein, mit der eine Spannung über dem abgeschalteten Halbleiterschalter aufgebaut wird, wenn seine Sperrfähigkeit besteht. Daraus ergibt sich die Geschwindigkeit der Messung. Die genannten Werte ermöglichen vorteilhaft eine ausreichend schnelle Messung in dem Zeitfenster, das die Abschaltung durch den Steuerimpuls festlegt und das je nach Ausgestaltung nur 10 µs oder weniger beträgt.

Bei dem erfindungsgemäßen Betriebsverfahren für ein Schaltgerät für ein Gleichspannungsnetz, das einen ersten steuerbaren Halbleiterschalter mit einem Steuerkontakt und zwei Lastkontakten aufweist, wird der erste Halbleiterschalter mittels eines elektrischen Steuersignals am Steuerkontakt gesteuert und weiterhin wird der erste Halbleiterschalter mit einem Steuerimpuls angesteuert, der bei einem funktionstüchtigen Halbleiterschalter ein Herabsetzen der elektrischen Leitfähigkeit des Halbleiterschalters bewirkt, für eine Zeitspanne, die weniger als 1 ms beträgt. Ein Strom wird auf eine Prüfschaltung aufgeprägt, wobei die Prüfschaltung den ersten Halbleiterschalter umfasst. Ein die Spannung oder die Spannungsänderung über den ersten Halbleiterschalter repräsentierender erster Wert wird als Folge des Steuerimpulses und des Aufprägens des Stroms ermittelt und aus dem ersten Wert ein Signal ermittelt und ausgegeben, das die Funktionstüchtigkeit des ersten Halbleiterschalters repräsentiert.

Ein wesentlicher Vorteil der Erfindung besteht darin, dass die Möglichkeit einer zuverlässigen Beurteilung der Funktionsfähigkeit des Schaltgeräts - vor allem bei solchen mit anti-seriell geschalteten Halbleiterschaltern geschaffen wird. Durch die Prüfung können beispielsweise Ausfälle aufgrund von Alterung, spontanem Versagen von Bauelementen oder Überbeanspruchung, zum Beispiel durch zu hohe Temperatur oder Spannung frühzeitig erkannt werden. Dies verhindert Schäden durch Folgefehler oder Produktionsausfälle aufgrund des Versagens der Schutz- oder Schaltfunktion, erhöht die Verfügbarkeit einer an ein Stromnetz angeschlossenen elektrischen Anlage und kann zudem die zeitlichen Abstände zwischen Wartungsintervallen steigern.

Die Prüfung kann dabei vorteilhaft im laufenden Betrieb durchgeführt werden. Es besteht also keine Notwendigkeit, für eine Prüfung des Schaltgeräts den oder jeden daran angeschlossenen Verbraucher abzuschalten. Dabei kommt es vorteilhaft nicht darauf an, dass beide Stromrichtungen innerhalb eines Prüfintervalls auftreten. Besonders vorteilhaft ist, dass eine Prüfung sogar dann möglich ist, wenn überhaupt kein Laststrom vorliegt.

Im Folgenden wird die Erfindung anhand der in den Figuren dargestellten Ausführungsbeispiele näher beschrieben und erläutert.

Es zeigen schematisch:
- Figur 1: ein Gleichspannungs-Netzwerk mit Teilnetzen,
- Figur 2: einen bidirektionalen Gleichspannungs-Schalter mit Entlastungsnetzwerk und Prüfschaltungen.

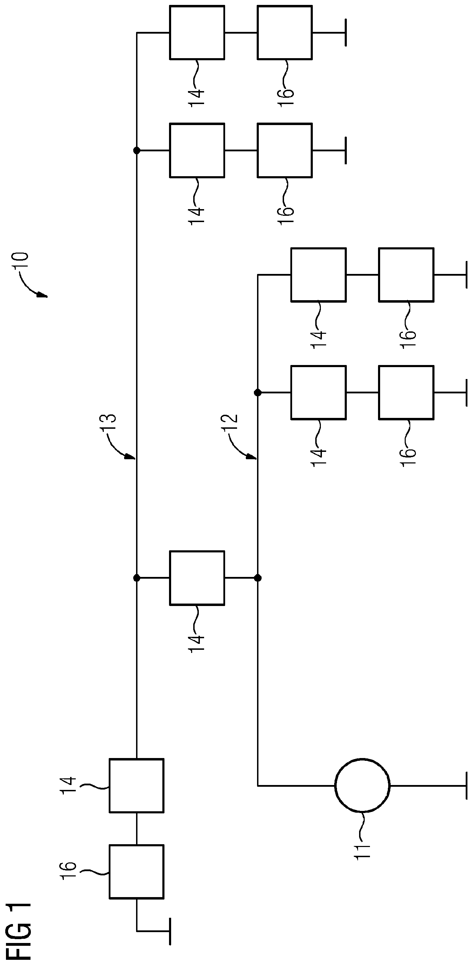

Figur 1 zeigt ein schematisiertes Gleichspannungsnetz 10 oder DC-Netzwerk 10. Das DC-Netzwerk 10 umfasst eine DC-Spannungsquelle 11, die das DC-Netzwerk 10 mit einer Gleichspannung versorgt. Die DC-Spannungsquelle 11 kann beispielsweise ein Gleichrichter sein, der mit einem Versorgungsnetzwerk verbunden ist. Es ist aber auch möglich, dass die DC-Gleichspannungsquelle ein Generator in Verbindung mit einem Gleichrichter ist.

Das DC-Netzwerk 10 umfasst weiterhin eine Reihe von Netzwerk-Teilnehmern 16. In der Figur 1 sind diese Netzwerk-Teilnehmer 16 alle gleichartig dargestellt, tatsächlich aber versteht es sich, dass die Netzwerk-Teilnehmer 16 sehr verschiedene Eigenschaften haben können. So können einer oder mehrere der Netzwerk-Teilnehmer 16 anstelle einer rein resistiven Last eine teils kapazitive oder induktive Last sein. Beispielsweise können ein Teil der Netzwerk-Teilnehmer 16 Elektro-Motoren sein. Ebenso ist es möglich, dass Netzwerk-Teilnehmer 16 Prosumer sind, also nicht nur als Energieverbraucher auftreten, sondern auch elektrische Energie in das DC-Netzwerk 10 zurückspeisen können. Beispielsweise können Netzwerk-Teilnehmer 16 einen Akkumulator enthalten. Schließlich können einige der Netzwerk-Teilnehmer 16 auch Generatoren sein oder enthalten, beispielsweise eine Photovoltaik-Anlage.

Das in Figur 1 gezeigte beispielhafte DC-Netzwerk 10 umfasst ein erstes und ein zweites Teilnetzwerk 12, 13. Das erste Teilnetzwerk 12 umfasst die DC-Spannungsquelle 11 und einige der Netzwerk-Teilnehmer 16. Das zweite Teilnetzwerk 13 umfasst einige weitere Netzwerk-Teilnehmer 16. Die beiden Teilnetzwerke 12, 13 sind im DC-Netzwerk 10 über einen Gleichspannungs-Schalter 14 oder kurz DC-Schalter 14 miteinander verbunden. Die Teilnetzwerke 12, 13 können also durch den DC-Schalter 14 voneinander getrennt werden. Da die Stromflussrichtung beim DC-Schalter 14 nicht sicher festlegbar ist, handelt es sich dabei um einen bidirektionalen DC-Schalter 14.

Nahe der weiteren Netzwerk-Teilnehmer 16 umfasst das DC-Netzwerk ebenfalls jeweils einen DC-Schalter 14. Für manche Anwendungen wäre es möglich, dass hier unidirektionale DC-Schalter zum Einsatz kommen. Für diese Beispiel wird aber davon ausgegangen, dass auch nahe der Netzwerk-Teilnehmer 16 bidirektionale DC-Schalter 14 verwendet werden.

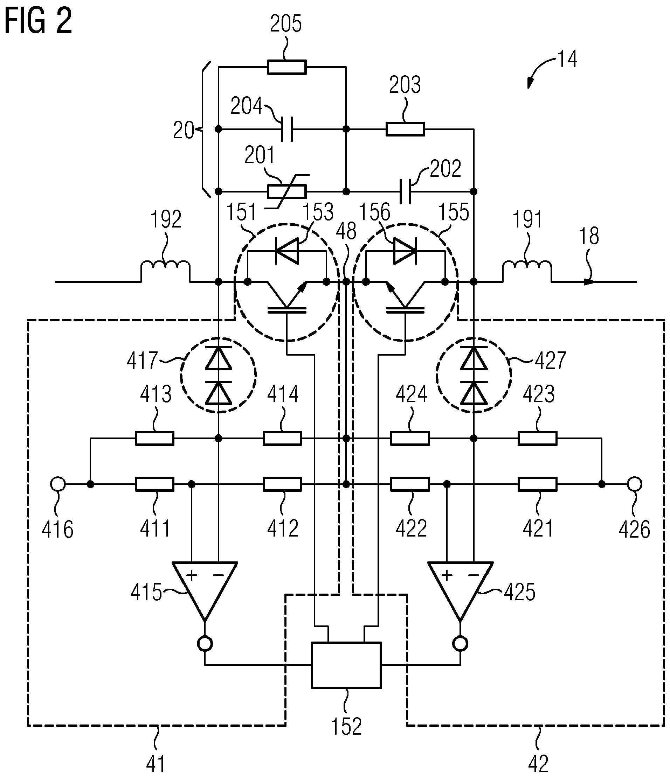

Figur 2 zeigt einen solchen bidirektionalen DC-Schalter 14, wie er in dem beispielhaften DC-Netzwerk 10 verwendet wird. Der DC-Schalter 14 umfasst einen ersten IGBT 151 mit einer parallelen Freilaufdiode 153. Ferner umfasst der DC-Schalter 14 eine Steuerung 152, die mit dem Gate-Anschluss des IGBT 151 verbunden ist und ihn im Betrieb des DC-Schalters 14 durch Steuersignale in Form von verschiedenen Spannungsniveaus ansteuert. Zusätzlich weist er einen zweiten IGBT 155 auf, der anti-seriell, also seriell und in der gegensätzlichen Orientierung, zum IGBT 151 geschaltet ist. Der zweite IGBT 155 weist ebenfalls eine parallele Freilaufdiode 156 auf, die ebenfalls entgegengesetzt zur Orientierung der Freilaufdiode 153 angeordnet ist. Auch der zweite IGBT 155 wird von der Steuerung 152 gesteuert, also mit einer Gatespannung versorgt. Der DC-Schalter 14 der Figur 2 ist dadurch ein bidirektionaler DC-Schalter, kann also einen Laststrom unabhängig von seiner Richtung abschalten.

Weiterhin umfasst der DC-Schalter 14 ein Entlastungsnetzwerk 20. Dieses weist drei Zweige auf, von denen ein erster und ein zweiter parallel zueinander und parallel zu den beiden IGBTs 151, 155 geschaltet ist. Der erste Zweig umfasst eine Serienschaltung eines Varistors 201 mit einem Kondensator 202. Der zweite Zweig umfasst eine Serienschaltung eines Widerstands 203 mit einem zweiten Kondensator 204. Der dritte Zweig umfasst einen zweiten Widerstand, der parallel zum zweiten Kondensator 204 geschaltet ist. Die Mittelanschlüsse zwischen den Elementen im ersten und zweiten Zweig sind ebenfalls verbunden.

Das Entlastungsnetzwerk 20 sorgt dafür, dass die induktiv im DC-Netzwerk 10, also beispielsweise in den Leitungsinduktivitäten 191, 192 gespeicherte Energie bei der Abschaltung durch den DC-Schalter 14 abgebaut wird, ohne zu Überspannungen zu führen, die zu einer Beschädigung der IGBTs 151, 155 führt. Neben der Form für das Entlastungsnetzwerk 20, die in Figur 2 dargestellt ist, gibt es andere Formen, die ebenso die beschriebenen Aufgaben übernehmen können.

Der DC-Schalter 14 ist seriell in eine DC-Leitung eingebunden, in der ein Strom in der Stromrichtung 18 fließt. Ein Defekt des DC-Schalters 14, der zu einem permanenten und ungewollten, also nicht durch die Steuerung 152 veranlassten hochohmigen Zustand führt, ist also im laufenden Betrieb direkt zu erkennen. Ein Zustand, bei dem der Schalter permanent niederohmig bleibt, kann hingegen nicht direkt erkannt werden, sondern erst bei der nächsten versuchten Abschaltung, wenn diese nicht funktioniert. Die Steuerung 152 des DC-Schalters 14 ist daher ausgestaltet, zur Funktionsprüfung für den DC-Schalter 14, also für die IGBTs 151, 155 mit einem passenden Steuerimpuls eine kurze Abschaltung der IGBTs 151, 155 durchzuführen.

Das Entlastungsnetzwerk 20 übernimmt dann, sofern die IGBTs 151, 155 funktionieren, den Laststrom. Dadurch, dass das Entlastungsnetzwerk 20 Kondensatoren im Strompfad aufweist, führt eine kurze Abschaltung der IGBTs 151, 155 zu einem annähernd linearen Anstieg der Spannung über den DC-Schalter 14, während der Laststrom über das Entlastungsnetzwerk 20 fließt und die Kondensatoren 202, 204 aufgeladen werden.

Das gilt aber nur, wenn die IGBTs 151, 155 bei einem Steuerimpuls der Steuerung 152, der normalerweise ein Abschalten bewirkt, beispielsweise eine Senkung der Gatespannung, auch tatsächlich dazu führt, dass die IGBTs 151, 155 nichtleitend werden. Somit kann durch eine Detektion der Spannung über den IGBTs 151, 155 ermittelt werden, ob die IGBTs 151, 155 in der vorgesehenen Weise auf den Steuerimpuls reagieren. Tun sie das, dann erfolgt ein Spannungsaufbau als Reaktion auf den Steuerimpuls. Erfolgt kein Spannungsaufbau oder ein zu geringer Spannungsaufbau, liegt eine Fehlfunktion vor. Zur Festlegung des Fehlerfalls kann beispielsweise eine Schwellspannung vorgesehen werden. Wird diese bedingt durch den Steuerimpuls nicht erreicht, liegt die Fehlfunktion vor.

Es ist zweckmäßig, wenn die Ausschaltzeit so bemessen ist, dass die Spannungsdifferenz zwischen Ein- und Ausgang des DC-Schalters 14 während der Dauer des Steuerimpulses nicht zu groß wird. Eine Dauer für den Steuerimpuls, die geringer ist, als 1 ms ist dafür zweckmäßig. Insbesondere reichen bereits Dauern von weniger als 10 µs für eine Funktionsprüfung des DC-Schalters 14. Durch geringe Dauern im ps-Bereich wird generell der Einfluss der Funktionsprüfung auf den laufenden Betrieb geringgehalten und speziell bei kapazitiven Lasten der Ausgleichsstrom beim Wiedereinschalten, also zum Ende des Steuerimpulses, niedrig gehalten.

In einer alternativen Ausführung des DC-Schalters 14 ist der Steuerimpuls so bemessen, dass er keine Abschaltung der IGBTs 151, 155 bewirkt, sondern nur eine Herabsetzung der Leitfähigkeit. Beispielsweise kann die Herabsetzung der Gatespannung geringer bemessen sein, als für eine völlige Abschaltung der IGBTs 151, 155 erforderlich wäre. Die IGBTs 151, 155 arbeiten dann weiterhin im aktiven Bereich und leiten den Laststrom. Dennoch steigt die Spannung über die IGBTs 151, 155 durch den Steuerimpuls an.

Auf diese Weise ist eine Funktionsprüfung für die IGBTs 151, 155 möglich, bei der die sich ergebende Spannung über die IGBTs 151, 155 geringer ausfällt bei einer völligen Abschaltung und somit Probleme mit Überspannung oder Ausgleichsströmen bei gleicher Dauer des Steuerimpulses geringer ausfallen. Die Steuerung 152 muss im Gegenzug dafür ausgestaltet sein, einen entsprechenden Steuerimpuls, also beispielsweise eine Absenkung der Gatespannung, erzeugen zu können.

Da die IGBTs 151, 155 jeweils eine parallele Freilaufdiode 153, 156 aufweisen, betrifft der Spannungsaufbau, der sich bedingt durch den Steuerimpuls ergibt, tatsächlich weitgehend nur einen der IGBTs 151, 155. Bei dem anderen IGBT 151, 155 wird der Aufbau einer Spannung durch die Freilaufdiode 153, 156 dagegen verhindert. Welcher der beiden IGBTs 151, 155 dabei nahezu spannungsfrei bleibt, hängt von der Richtung des fließenden Laststroms ab. Fließt der Laststrom in Figur 2 von der Seite des IGBT 151 zur Seite des IGBT 155, fällt der Spannungsaufbau auf den IGBT 151. Im anderen Fall ergibt sich ein Spannungsaufbau nur über den IGBT 155.

Mit der beschriebenen Methode zur Feststellung, ob die IGBTs 151, 155 leitend defekt sind, kann daher nur einer der beiden IGBTs 151, 155 tatsächlich getestet werden, solange nicht beide Laststrom-Richtungen für die Messung zur Verfügung stehen. Fällt der Laststrom für einen Zeitraum ganz weg, kann sogar keiner der beiden IGBTs 151, 155 getestet werden.

Um diesem Problem zu begegnen, umfasst der DC-Schalter 14 zusätzlich eine erste und eine zweite Prüfschaltung 41, 42, wobei die erste Prüfschaltung 41 zur Funktionsprüfung des ersten IGBTs 151 dient und die zweite Prüfschaltung 42 zur Funktionsprüfung des zweiten IGBTs 155. Die erste und zweite Prüfschaltung 41, 42 sind spiegelbildlich aufgebaut.

Sie umfassen jeweils einen ersten Spannungsteiler, der durch einen ersten und zweiten Prüfwiderstand 411,412, 421, 422 gebildet ist. Sie umfassen weiterhin einen zweiten Spannungsteiler, der einen dritten und vierten Prüfwiderstand 413, 414, 423, 424 umfasst. Dabei sind die ersten und zweiten Spannungsteiler an einem ihrer Außenanschlüsse miteinander verbunden und mit dem Knoten 48 zwischen den beiden IGBTs 151, 155, also mit deren Emittern verbunden. Die anderen Außenanschlüsse sind mit einem Hilfspotential 416, 426 verbunden, das beispielsweise +15V gegenüber dem Knoten 48 beträgt.

Der Mittelpunkt der zweiten Spannungsteiler ist über eine oder mehrere Entkopplungsdioden 417, 427, die die im Betrieb anliegende Spannung blockieren können müssen, mit dem Kollektor des jeweiligen IGBTs 151, 155 verbunden. Weiterhin ist der Mittelpunkt der zweiten Spannungsteiler mit dem invertierenden Eingang eines Operationsverstärkers 415, 425 der jeweiligen Prüfschaltung 41, 42 verbunden. Der Mittelpunkt der ersten Spannungsteiler ist mit dem nicht-invertierenden Eingang des jeweiligen Operationsverstärkers 415, 425 verbunden. Die Ausgänge der Operationsverstärker 415, 425 sind mit der Steuerung 152 verbunden und geben das Ergebnis der Funktionsprüfung an die Steuerung 152 weiter.

Die ersten Spannungsteiler bilden eine Referenzspannung aus. Es können beispielsweise Widerstandswerte von 1 kOhm für den jeweils ersten Prüfwiderstand 411, 421 und 2 kOhm für den jeweils zweiten Prüfwiderstand 412, 422 verwendet werden, was im hier gegebenen Beispiel zu einer Referenzspannung von 10 V am nicht-invertierenden Eingang des Operationsverstärkers 415, 425 führt.

Bei dem zweiten Spannungsteiler können beispielsweise Widerstandswerte von 1 kOhm für den jeweils dritten Prüfwiderstand 413, 423 und 3 kOhm für den jeweiligen vierten Prüfwiderstand 414, 424 verwendet werden. Einer der beiden IGBTs 151, 155 ist zum jeweiligen vierten Prüfwiderstand 414, 424 parallelgeschaltet. Die IGBTs 151, 155 sind somit auch Teil der jeweiligen Prüfschaltung 41, 42.

Ist ein jeweiliger IGBT 151, 155 in dem kurzen Zeitraum, in dem die beiden IGBTs 151, 155 durch den Steuerimpuls ausgeschaltet werden, funktionstüchtig, also tatsächlich hochohmig, führt das zu einer Spannung entsprechend dem zweiten Spannungsteiler, also 11,25 V, am invertierenden Eingang des jeweiligen invertierenden Eingang des Operationsverstärkers 415, 425. Da diese Spannung höher ist als die Referenzspannung, gibt der jeweilige Operationsverstärker 415, 425 am Ausgang ein "low"-Signal aus, was als Signal für einen funktionstüchtigen IGBT 151, 155 verarbeitet werden kann.

Ist der getestete IGBT 151, 155 dagegen trotz des Steuerimpulses leitend, also defekt, fällt die Spannung am invertierenden Eingang auf einen Wert, der der Summe aus den Flussspannungen der Entkopplungsdioden 417, 427 und IGBT 151, 155 entspricht, also ca. 3 V gegenüber dem Knoten 48. Der jeweilige Operationsverstärker 415, 425 gibt in der Folge am Ausgang ein "high"-Signal aus, was als Signal für einen leitend defekten IGBT 151, 155 verarbeitet werden kann.

Da bei dieser Messfunktion eine möglichst schnelle Messung interessant ist, werden im Gegensatz zu bekannten Sättigungsmessungen für IGBTs höhere Ströme verwendet und daher geringere dritte und vierte Prüfwiderstände 413, 414, 423, 424.

Auf diese Weise wird also ein DC-Schalter 14 geschaffen, der in der Lage ist, im laufenden Betrieb, also unter Laststrom, seine steuerbaren Halbleiterschalter darauf zu testen, ob sie leitend defekt sind und einen entsprechenden Defekt zu erkennen, bevor der nächste Ausschaltvorgang tatsächlich ansteht. Dabei kann auch derjenige von zwei anti-seriellen IGBTs 151, 155 getestet werden, der aufgrund der Stromrichtung auch durch eine Abschaltung nicht unter Spannung gesetzt werden kann. Dabei wird ausgenutzt, dass das Entlastungsnetzwerk bei der Abschaltung den Laststrom übernimmt und dem betroffenen spannungsfreien IGBT 151, 155 ein Strom aufgeprägt werden kann. Der sich nur bei einem funktionierenden IGBT 151, 155 ergebende Spannungsabfall wird als Signal für die Funktionsprüfung ausgewertet.

Darüber hinaus ermöglicht der Aufbau des DC-Schalters gemäß der Figur 4 sogar eine Funktionsprüfung im laststromfreien Zustand. Liegt überhaupt kein Laststrom in dem jeweiligen Teilnetz 12, 13 vor, in dem der DC-Schalter 14 angeordnet ist, dann können durch das Aufprägen des Stroms durch die Prüfschaltungen 41, 42 sogar die Sperr- und die Leitfähigkeit getestet werden, wobei die Steuerung 152 dazu die IGBTs 151, 155 passend für kurze Zeitabschnitte an- und abschalten muss.

Es versteht sich, dass die Auswertung der sich ergebenden Spannungen durch die Abschaltung und die Aufprägung eines Stroms auf verschiedene Weise ausgewertet werden können, beispielsweise analog oder digital, durch einen Komparator oder beispielsweise durch direkten Anschluss an einen Mikrocontroller. Ein sich ergebendes Signal, das die Funktionsfähigkeit der IGBTs 151, 155 repräsentiert, kann ebenfalls verschiedene Ausprägungen annehmen. So kann das Signal in einem Protokoll gespeichert werden, als optisches oder akustisches Signal ausgegeben werden oder als elektrisches Signal einer übergeordneten Steuerung oder Auswerteeinheit zugeführt werden oder mehrere dieser Möglichkeiten.

### Bezugszeichenliste

- 10: DC-Netzwerk
- 11: DC-Spannungsquelle
- 12, 13: Teilnetze
- 14: DC-Schalter
- 16: Netzwerk-Teilnehmer
- 151, 155: IGBT
- 152: Steuerung
- 153, 156: Freilaufdiode
- 154: parasitäre Kapazität
- 18: Laststrom
- 191, 192: Leitungs-Induktivität
- 20: Entlastungsnetzwerk
- 201: Varistor
- 202, 204: Kondensator
- 203, 205: Entlastungswiderstand
- 41, 42: Prüfschaltung
- 411...414: Prüfwiderstand
- 421...424: Prüfwiderstand
- 415, 425: Operationsverstärker
- 416, 426: Hilfspotential
- 417, 427: Entkopplungsdioden
- 48: Knoten

## Patentansprüche

1. Schaltgerät (14) für ein Gleichspannungsnetz (10) mit einem ersten steuerbaren Halbleiterschalter (151, 155), der einen Steuerkontakt und zwei Lastkontakte aufweist und einer Steuerung (152) für den ersten Halbleiterschalter (151, 155), ausgestaltet, den ersten Halbleiterschalter (151, 155) mittels eines elektrischen Steuersignals am Steuerkontakt zu steuern, wobei die Steuerung (152) ausgestaltet ist, folgende Schritte vorzunehmen:
- Ansteuern des ersten Halbleiterschalters (151, 155) mit einem Steuerimpuls, der bei einem funktionstüchtigen Halbleiterschalter (151, 155) ein Herabsetzen der elektrischen Leitfähigkeit des Halbleiterschalters (151, 155) bewirkt, für eine Zeitspanne, die weniger als 1 ms beträgt,
- Aufprägen eines Stroms auf eine Prüfschaltung (41, 42), die den ersten Halbleiterschalter (151, 155) umfasst,
- Ermitteln eines die Spannung oder die Spannungsänderung über den ersten Halbleiterschalter (151, 155) repräsentierenden ersten Werts als Folge des Steuerimpulses und des Aufprägens,
- Ermitteln aus dem ersten Wert und Ausgabe eines Signals, das die Funktionstüchtigkeit des ersten Halbleiterschalters (151, 155) repräsentiert.

2. Schaltgerät (14) nach Anspruch 1, bei dem die Steuerung (152) ausgestaltet ist, als Zeitspanne weniger als 10 µs zu verwenden.

3. Schaltgerät (14) nach Anspruch 1 oder 2, bei dem die Steuerung (152) ausgestaltet ist, den Halbleiterschalter (151, 155) mit dem Steuerimpuls abzuschalten.

4. Schaltgerät (14) nach einem der vorangehenden Ansprüche mit einem zweiten steuerbaren Halbleiterschalter (151, 155), wobei die Steuerung (152) ausgestaltet ist, beide Halbleiterschalter (151, 155) mit dem Steuerimpuls anzusteuern.

5. Schaltgerät (14) nach Anspruch 4, bei dem die Halbleiterschalter (151, 155) jeweils eine parallele Freilaufdiode (153, 156) umfassen und anti-seriell geschaltet sind, wobei der Steuerimpuls beim zweiten Halbleiterschalter (151, 155) einen Spannungsaufbau bewirkt, während beim ersten Halbleiterschalter (151, 155) der Spannungsaufbau durch die Freilaufdiode (153, 156) begrenzt wird, wobei die Steuerung (152) ausgestaltet ist, zusätzlich folgende Schritte vorzunehmen:
- Ermitteln eines die Spannung oder die Spannungsänderung über den zweiten Halbleiterschalter (151, 155) repräsentierenden zweiten Werts als Folge des Steuerimpulses,
- Ermitteln aus den Werten und Ausgabe eines Signals, das die Funktionstüchtigkeit beider Halbleiterschalter (151, 155) repräsentiert.

6. Schaltgerät (14) nach Anspruch 4 oder 5 mit einer Prüfschaltung (41, 42) für jeden der Halbleiterschalter (151, 155) .

7. Schaltgerät (14) nach einem der vorangehenden Ansprüche, bei dem die Prüfschaltung (41, 42) einen resistiven Spannungsteiler umfasst, zu dessen einem Widerstand (414, 424) der Halbleiterschalter (151, 155) parallelgeschaltet ist.

8. Schaltgerät (14) nach Anspruch 7, bei dem die Widerstände (413, 414, 423, 424) des resistiven Spannungsteilers Widerstandwerte von weniger als 10 kOhm, insbesondere weniger als 5 kOhm aufweisen.

9. Betriebsverfahren für ein Schaltgerät (14) für ein Gleichspannungsnetz (10) mit einem ersten steuerbaren Halbleiterschalter (151, 155), der einen Steuerkontakt und zwei Lastkontakte aufweist, bei dem der erste Halbleiterschalter (151, 155) mittels eines elektrischen Steuersignals am Steuerkontakt gesteuert wird, bei dem:
- der erste Halbleiterschalter (151, 155) mit einem Steuerimpuls angesteuert wird, der bei einem funktionstüchtigen Halbleiterschalter (151, 155) ein Herabsetzen der elektrischen Leitfähigkeit des Halbleiterschalters (151, 155) bewirkt, für eine Zeitspanne, die weniger als 1 ms beträgt,
- ein Strom auf eine Prüfschaltung (41, 42) aufgeprägt wird, die den ersten Halbleiterschalter (151, 155) umfasst,
- ein die Spannung oder die Spannungsänderung über den ersten Halbleiterschalter (151, 155) repräsentierender erster Wert als Folge des Steuerimpulses und des Aufprägens ermittelt wird,
- aus dem ersten Wert ein Signal ermittelt und ausgegeben wird, das die Funktionstüchtigkeit des ersten Halbleiterschalters (151, 155) repräsentiert.

10. Betriebsverfahren nach Anspruch 9 für ein Schaltgerät (14) für ein Gleichspannungsnetz (10), wobei das Schaltgerät (14) einen ersten und zweiten steuerbaren Halbleiterschalter (151, 155) aufweist, wobei die Halbleiterschalter (151, 155) jeweils eine parallele Freilaufdiode (153, 156) umfassen und anti-seriell geschaltet sind, bei dem:
- beide Halbleiterschalter (151, 155) mit dem Steuerimpuls angesteuert werden, wodurch beim zweiten Halbleiterschalter (151, 155) ein Spannungsaufbau bewirkt wird, während beim ersten Halbleiterschalter (151, 155) durch die Freilaufdiode (153, 156) der Spannungsaufbau begrenzt wird,
- ein die Spannung oder die Spannungsänderung über den zweiten Halbleiterschalter (151, 155) repräsentierender zweiter Wert als Folge des Steuerimpulses ermittelt wird,
- aus dem ersten und zweiten Wert ein Signal ermittelt und ausgegeben wird, das die Funktionstüchtigkeit der Halbleiterschalter (151, 155) repräsentiert.
